# EUROPEAN PATENT SPECIFICATION

(11) **EP 3 809 472 B1**
(45) Date of publication and mention of the grant of the patent: **05.04.2023**
(21) Application number: 20200333.1
(22) Date of filing: 06.10.2020
(51) Int. Cl.: H01L 31/107

(54) **A SINGLE-PHOTON AVALANCHE DIODE AND A SENSOR ARRAY**
EIN-PHOTONEN-LAWINENDIODE UND SENSORANORDNUNG
DIODE À AVALANCHE MONOPHOTONIQUE ET RÉSEAU DE CAPTEURS

(30) Priority: 18.10.2019 EP 19204088
(43) Date of publication of application: 21.04.2021
(73) Proprietor: Imec VZW, 3001 Leuven (BE); Katholieke Universiteit Leuven KU Leuven Research & Development, 3000 Leuven (BE)
(72) Inventor: VAN SIELEGHEM, Edward, 3001 Leuven (BE)
(74) Representative: AWA Sweden AB

(56) References cited:
- CN-A- 108 039 390
- CN-A- 109 346 552
- US-A1- 2012 299 141
- XIAO Z ET AL: "A New Single Photon Avalanche Diode in CMOS High-Voltage Technology", SOLID-STATE SENSORS, ACTUATORS AND MICROSYSTEMS CONFERENCE, 2007. TRANSDUCERS 2007. INTERNATIONAL, IEEE, PISCATAWAY, NJ, USA, 10 June 2007 (2007-06-10), pages 1365-1368, XP031216296, ISBN: 978-1-4244-0841-2

## Description

### Technical field

The present disclosure generally relates to the field of light detection. More in particular, the present disclosure relates to light detection using single-photon avalanche diodes, which may be arranged in an array.

### Background

A commonly-used technique for single-photon detection is based on solid-state avalanche photodiodes. Such devices may be operated in the so-called Geiger mode, meaning that individual photo-generated charges are multiplied into detectable charge packets through impact ionization in a large electric field. When operating in this mode, the detector may be referred to as a single-photon avalanche diode (SPAD). For many applications, including for example range-finding, detecting near-infrared (NIR) radiation with high efficiency using such SPAD detectors may be important.

To exploit well-established semiconductor processing platforms, and to simplify on-chip integration of CMOS circuitry, there may be a strong interest in developing and fabricating arrays of such SPADs in silicon. However, due to the low energy (~1eV) of NIR radiation, silicon provides a small absorption coefficient for such radiation. Therefore, a large depleted volume may be required in addition to a large electric field. This may introduce trade-offs between detection speed, noise, uniformity, and sensitivity. Implementing arrays of SPADs in silicon may thus be challenging.

### Summary

An objective of the present inventive concept is to provide a single-photon avalanche diode that enables detection of photons with a relatively high uniformity and sensitivity.

These and other objects of the invention are at least partly met by the invention as defined in the independent claims. Preferred embodiments are set out in the dependent claims.

XIAO Z ET AL: "A New Single Photon Avalanche Diode in CMOS High-Voltage Technology", SOLID-STATE SENSORS, ACTUATORS AND MICROSYSTEMS CONFERENCE, 2007, discloses a single photon avalanche diode (SPAD) implemented in a commercially available high-voltage CMOS technology. The SPAD was designed with relatively low-doped layers to form p-/n-junction, instead of commonly adopted p+/n- or n+/p-structures. Readily available layers were used as given by the technology without any customization or post-processing. Careful design measures were taken to ensure planar junction breakdown. Compared with a p+/n- diode, a p-/n- SPAD has relative deep junction, wide depletion region, and thus improves probability of photon detection. The measurement shows a maximum photon detection efficiency of 34.4%, and remains above 20% from 400nm to 620nm, whereas the dark count rate is only 50cps at room temperature with 5V excess voltage.

US 2012/299141 A1 discloses an avalanche photodiode including a semiconductor substrate of a first conductivity type, an avalanche multiplication layer, an electric field control layer, a light absorption layer, and a window layer wherein the layers are laid one on another in this order on a major surface of the semiconductor substrate, an impurity region of a second conductivity type in a portion of the window layer, and a straight electrode on the impurity region and connected to the impurity region, the straight electrode being straight as viewed in a plan view facing the major surface of the semiconductor substrate.

CN 109346552 A discloses an avalanche photodetector based on an arc diffusion region and a manufacturing method of the avalanche photodetector. The avalanche photodetector comprises an epitaxial structure, a passivation layer, a P type electrode layer, an N type electrode layer, and an antireflection film. The epitaxial structure comprises an N-type substrate, an absorption layer, a charge layer and an intrinsic multiplication layer from the bottom up. A 3D bowl-shaped opening is formed in the intrinsic multiplication layer, and a P-type highly-doped arc-shaped diffusion region is formed under the 3D bowl-shaped opening. The passivation layer is formed on the epitaxial structure. The P-type electrode layer is in contact with the P-type highly-doped arc-shaped diffusion region. The N-type electrode layer is in contact with the N-type substrate. The antireflection film, which serves as a light window, is arranged on the front surface or the back surface of the single-electron avalanche photodetector. The connecting line of the center of the antireflection film and the curvature center of the arc-shaped diffusion area is parallel to the extension direction, and the light field central area of the light window coincides with a high field area in space. According to the avalanche photodetector, the photon detection efficiency of the device is effectively improved, the dark count of the device is reduced, and the probability of the post pulse is reduced.

According to a first aspect of the present inventive concept, there is provided a single-photon avalanche diode (SPAD) as defined in claim 1 for use in a complementary metal-oxide-semiconductor (CMOS) integrated circuit and adapted for detection of light, such as visible or near infrared light, the SPAD comprising: a semiconductor substrate comprising a top surface at a front side and a back side opposite to the front side; an inner doped region disposed at a top surface of a semiconductor substrate connected to a first terminal, wherein a geometrical structure of a boundary of the inner doped region is rotationally symmetric in a horizontal direction of the semiconductor substrate and wherein the inner doped region comprises dopant implantations of a first type; at least one outer doped region disposed at a top surface of a semiconductor substrate connected to a second terminal, wherein the at least one outer doped region is arranged to at least partially enclose the inner doped region in the horizontal direction of the semiconductor substrate and wherein the outer doped region comprises dopant implantations of a second type; a lowly doped depletion volume, which is arranged to surround the rotationally symmetric inner doped region and which comprises dopant implantations of the first type or dopant implantations of the second type; wherein a depth of the lowly doped depletion volume extending from the top surface of the semiconductor substrate into the semiconductor substrate is larger than a depth of the at least one outer doped region, wherein the second terminal and the back side of the semiconductor substrate are commonly connected, and wherein one of the first and the second terminal forms an anode and another of the first and the second terminal forms a cathode, the anode and the cathode being separated by the lowly doped depletion volume; wherein the SPAD is configured such that, when a reverse bias is applied to the anode, an electric field peak around the inner doped region is formed to enable impact ionization and multiplication of charges; anc wherein a surface of the inner doped region at a doping transition to the lowly doped region is rotationally symmetric and contains no sharp corners, such that the electric field peak being spherically uniform around the first terminal and spaced away from the top surface.

The SPAD according to the first aspect may provide a localized electric field peak which is controlled by the geometry of implants. This implies that there is control over generation of the localized electric field peak, which makes the SPAD relatively insensitive to process variations.

Further, the SPAD may provide a high photon detection efficiency and may be particularly useful for detection of near infrared light, although the SPAD may also or alternatively be used for detection of other wavelengths.

The electric field in the depletion volume can be represented by field lines. When a reverse bias is applied, field lines start at an edge of a space charge region near the doped region that is electrically connected to the terminal with the higher potential and end at the edge of the space charge region near the doped region that is electrically connected to the terminal with the lower potential. Because the inner doped region is at least partially enclosed by the outer doped region, the surface of the edge of the space charge region around the inner doped region is smaller than the surface of the edge of the space charge region near outer doped regions and the bottom surface of the lowly doped depletion volume. Consequently, the field line density must be larger near the inner doped region. This results in a local field peak near the inner doped region. Therefore, the geometry of the SPAD may provide a localized electric field peak, which may be approximately uniform, close to the inner doped region which may facilitate light detection.

Thanks to the boundary of the inner doped region being rotationally symmetric, a uniform arrangement of the localized electric field peak may be provided around the inner doped region.

Thanks to the arrangement of the SPAD, the combined doping profiles of the inner doped region and the outer doped region may be configured such that the field peak around the inner doped region does not extend entirely to an oxide interface at the top surface. Consequently, charges generated on a defective oxide interface have a lower probability of being multiplied. Additionally, charge trapping of carriers generated by an avalanche event is less likely.

The dopant implantations of the first type are different than the dopant implantations of the second type.

As used herein, "top surface" should be construed as providing a relation of the top surface to other parts of the SPAD. Thus, when the semiconductor substrate is oriented with the front side facing upwards, the top surface will be an uppermost surface of the semiconductor substrate. However, it should further be realized that there may be other structures arranged on or above the "top surface", such that the "top surface" need not necessarily be an uppermost surface of the SPAD.

As used herein, "horizontal direction of the semiconductor substrate" should be construed as a direction along or parallel to a main extension of the semiconductor substrate, e.g. parallel to an extension of the top surface.

As used herein, a geometrical structure being "rotationally symmetric" should be construed as the geometrical structure having any shape, wherein the geometrical structure is symmetric around a central axis. Since the geometrical structure is symmetric in a horizontal direction, the geometrical structure is symmetric around a central axis being normal to the horizontal direction of the semiconductor substrate.

As used herein, "at least partially enclose" should be interpreted as the at least one outer doped region being arranged around the inner doped region, but the outer doped region need not necessarily form a closed shape that completely encloses the inner doped region. Rather, one or more openings in the shape formed by the at least one outer doped region may be present around the inner doped region. The openings in the shape may be symmetrically arranged around the inner doped region with outer doped regions being concentrically arranged around the inner doped region with an equal angular spacing between adjacent outer doped regions.

The lowly doped depletion volume may be arranged such that the lowly doped depletion volume is arranged between the at least one outer doped region and the inner doped region.

According to an embodiment, the at least one outer doped region is arranged to at least partially enclose the inner doped region such that, when the reverse bias is applied to the anode, a surface of a space charge region at the at least one outer doped region is larger than a surface of a space charge region at the inner doped region.

Hence, the at least one outer doped region may be arranged in such manner that the partial enclosing of the inner doped region may ensure that the surface of the space charge region of the at least one outer doped region is larger than the surface of the space charge region at the inner doped region. This implies that it is ensured that the field line density is larger near the inner doped region.

According to an embodiment, a ratio of a depth of the lowly doped depletion volume to a horizontal spacing at the top surface between the inner doped region and the outer doped region is in a range of 1-4.

If the depth is too large, full depletion of the lowly doped depletion volume at the breakdown voltage may be difficult to achieve in a vertical direction. If the depth is too small, vertical depletion may occur at a lower voltage than the breakdown voltage.

According to an embodiment, a horizontal spacing at the top surface between the inner doped region and the outer doped region is in a range of 2-10 µm.

If the spacing is too large, full depletion of the lowly doped depletion volume at the breakdown voltage may be difficult to achieve in the horizontal direction. If the depth is too small, horizontal depletion may occur at a lower voltage than the breakdown voltage.

According to an embodiment, a depth of the lowly doped depletion volume is in a range of 5-30 µm.

This may be a suitable depth in order to provide desired characteristics for depletion of the lowly doped depletion volume.

According to an embodiment, the boundary of the inner doped region is a surface of a volume in which a dopant concentration is above 1*10¹⁶ cm⁻³ and wherein the boundary forms a half sphere.

This may be a suitable dopant concentration. Thanks to the boundary forming a half sphere, uniform field lines around the inner doped region may be formed and the localized electric field peak may be approximately uniform, close to the inner doped region.

According to an embodiment, doping gradients at the boundary between the inner doped region and the lowly doped depletion volume is below 1*10¹⁹ cm⁻³ µm⁻¹.

Thanks to the doping gradients being small, it may be ensured that no sharp corners or excessively steep doping gradients exist at the boundary between the inner doped region and the lowly doped depletion volume. This enables a localized field peak facilitating impact ionization and Geiger mode multiplication of charges.

The low doping gradient may be provided exactly at the boundary between the inner doped region and the lowly doped depletion volume, but the low doping gradient may also be provided in proximity of the boundary, such as extending +- 0.1 µm from the boundary.

According to an embodiment, a ratio between a depth and a radius of the rotationally symmetric geometrical structure is in a range of 0.7-1.3.

The ratio between the depth and the radius of the rotationally symmetric geometrical structure may be around 1.

The shape of the rotationally symmetric geometrical structure may thus facilitate formation of uniform field lines around the inner doped region.

According to an embodiment, a depth of the rotationally symmetric geometrical structure is in a range of 0.3-1.5 µm and a radius of the rotationally symmetric geometrical structure is in a range of 0.3-1.5 µm.

A small size of the rotationally symmetric geometrical structure may enforce local crowding of the electric field lines to form the localized electric field peak.

According to an embodiment, the lowly doped depletion volume is configured to extend to a highly doped region at the back side.

The highly doped region may be commonly connected to the second terminal. The highly doped region may have a large thickness such as being up to 1 mm thick. The highly doped region may have a dopant concentration above 1*10¹⁸ cm⁻³.

The lowly doped depletion volume may extend to the highly doped region or may transition into the highly doped region through a region of gradually increasing dopant concentration.

According to an embodiment, the SPAD is configured for back side illumination, wherein the highly doped region is disposed at a surface of the back side, wherein a thickness of the highly doped region is below 1 µm and a dopant concentration is above 1*10¹⁸ cm⁻³.

This may be suitable for facilitating detection of light incident at the back side.

According to an embodiment, the SPAD is configured for front side illumination, the highly doped region has a dopant concentration above 1*10¹⁸ cm⁻³ and has a thickness below 1 mm.

This may facilitate that light incident on the back side of the semiconductor substrate does not affect detection of front side illumination.

According to an embodiment, a doping concentration of the lowly doped depletion volume is below 1*10¹⁴ cm⁻³.

This implies that very few dopant implantations are present in the lowly doped depletion volume. The lowly doped depletion volume may be seen as having a (nearly) intrinsic doping.

According to an embodiment, a doping concentration in the lowly doped depletion volume is graded towards a higher doping concentration farther away from the top surface.

Thus, the lowly doped depletion volume may gradually transition into the highly doped region at a back side of the semiconductor substrate.

According to an embodiment, the lowly doped depletion volume comprises dopant implantations of p-type.

This may be a suitable doping of the lowly doped depletion volume. However, doping types may be interchanged.

According to an embodiment, the lowly doped depletion volume is depleted to at least 60% of its volume.

This implies that the lowly doped depletion volume provides an at least nearly fully depleted volume. The generated carriers may thus move quickly to the inner doped region connected to the first terminal and the outer doped regions connected to the second terminal.

According to an embodiment, the inner doped region comprises an innermost region surrounded by an outermost region, wherein the innermost region has a higher doping concentration than the outermost region.

This implies that an outermost region of the inner doped region may present a region which is non-depleted to a high degree at operating conditions. The innermost region may have a doping concentration suitable for providing a contact with the first terminal.

According to an embodiment, the outermost region defines the boundary of the inner doped region.

According to an embodiment, the innermost region is configured to form an ohmic contact with the first terminal. This facilitates a good contact between the inner doped region and the first terminal.

According to an embodiment, the inner doped region comprises iso-concentration surfaces that define a doping profile of the inner doped region. An outermost iso-concentration surface may also define a boundary of the inner doped region.

According to an embodiment, the iso-concentration surfaces of the outermost region of the inner doped region form approximate half spheres for concentrations ranging from 1*10¹⁸ cm⁻³ to 1*10¹⁶ cm⁻³.

Thus, forming of uniform field lines around the inner doped region may be facilitated.

According to an embodiment, the iso-concentration surface with concentration 1*10¹⁷ cm⁻³ has a radius in a range of 0.5-1.0 µm.

Thus, a small size of the rotationally symmetric geometrical structure may be provided to enforce local crowding of the electric field lines to form the localized electric field peak.

According to an embodiment, the inner doped region comprises dopant implantations of n-type and wherein the outer doped region comprises dopant implantations of p-type.

This may be a suitable doping of the inner doped region and the outer doped region. However, doping types may be interchanged.

According to an embodiment, each of the at least one outer doped region comprises a highly doped region and a moderately doped region, the highly doped region having a higher doping concentration than the moderately doped region.

This implies that the highly doped region may be provided with a doping concentration suitable for providing a contact with the second terminal. The moderately doped region may define a boundary of the outer doped region and may be partially depleted at a transition of the outer doped region to the lowly doped depletion volume.

According to an embodiment, the highly doped region is configured to form an ohmic contact with the second terminal. This facilitates a good contact between the outer doped region and the second terminal.

According to an embodiment, the moderately doped region is arranged closer to the inner doped region than the highly doped region and wherein the moderately doped region defines the depth of the at least one outer doped region.

The moderately doped region may be designed with a shape and size such that the lowly doped depletion volume which extends between the outer doped region and the inner doped region may be depleted to a high degree and such that uniform field lines may be formed around the inner doped region.

According to an embodiment, the outer doped region comprises iso-concentration surfaces that define a doping profile of the outer doped region. An outermost iso-concentration surface may also define a boundary of the outer doped region.

According to an embodiment, a distance between the top surface and the back side is larger than a smallest distance between a center of the inner doped region and an iso-concentration surface with concentration 1*10¹⁷ cm⁻³ in the outer doped region by a factor between 1 and 4.

The lowly doped depletion volume may extend in a major portion of the distance between the top surface and the back side. If the distance is too large, full depletion of the lowly doped depletion volume at the breakdown voltage may be difficult to achieve in a vertical direction. If the distance is too small, vertical depletion may occur at a lower voltage than the breakdown voltage.

According to an embodiment, the depth of the outer doped region is in a range of 0.5-3.5 µm.

This implies that the outer doped region may relate to the inner doped region for forming uniform field lines around the inner doped region.

According to an embodiment, the outer doped region comprises a portion bulging inwards from the top surface.

This may be beneficial in ensuring that charge trapping at the top surface of carriers generated by an avalanche event is less likely. The portion bulging inwards may ensure that the distance between the inner and outer doped region increases near the top surface, which may ensure that localized field peak does not extend to the top surface.

According to an embodiment, the SPAD further comprises a shallow lowly doped region at the top surface between the inner doped region and the outer doped region and above the lowly doped depletion volume.

This may further reduce a localized field peak at the top surface.

According to an embodiment, the shallow lowly doped region comprises dopant implantations of the first type and has a doping concentration in a range of 1*10¹² cm⁻³ to 1*10¹⁵ cm⁻³.

This may be a suitable doping concentration of the shallow lowly doped region. The shallow lowly doped region may also be configured in relation to an effect of the shallow lowly doped region on electric field lines in a remainder of the SPAD.

According to an embodiment, the shallow lowly doped region has a thickness that is smaller than 200 nm.

This may be a suitable thickness of the shallow lowly doped region in order for the shallow lowly doped region to reduce localized filed peak only at the top surface of the semiconductor substrate.

According to an embodiment, the SPAD is configured such that, when the reverse bias is applied to the second terminal and the back side of the semiconductor substrate, the electric field peak does not extend to the top surface. The shallow lowly doped region may be depleted by more than 90% of its volume. Thus, charges generated on a defective interface between the top surface and an oxide above have a lower probability of being multiplied. Additionally, charge trapping of carriers generated by an avalanche event is less likely.

According to an embodiment, the SPAD is configured such that, when a reverse bias of 50V is applied to the anode, the electric field peak enabling impact ionization and multiplication of charges is formed.

This implies that the electric field peak may be formed while applying a relatively small voltage of 50V. It should be realized that the electric field peak may be formed with even lower voltages being applied, but the electric field peak should at least be formed when a reverse bias of 50V is applied to the anode.

According to an embodiment, the SPAD further comprises a top layer of silicon dioxide arranged above the top surface of the semiconductor substrate, wherein connections between the inner doped region and the first terminal and between the at least one outer doped region and the second terminal extend through the top layer.

The top layer of silicon dioxide may ensure electric isolation between the first and second terminals. Further, it should be realized that other materials than silicon dioxide may be used.

According to an embodiment, the at least one outer doped region is configured to completely enclose the inner doped region in the horizontal direction of the semiconductor substrate.

This may facilitate that uniform field lines may be formed around an entire circumference of the inner doped region, as the outer doped region completely encloses the inner doped region.

According to an embodiment, the at least one outer doped region is configured to circularly enclose the inner doped region.

This may further facilitate that uniform field lines are formed around the inner doped region.

According to an embodiment, the at least one outer region comprises a plurality of outer regions, wherein the plurality of outer regions together enclose the inner doped region forming an n-fold symmetry around the inner doped region, where n > 3.

Thus, the plurality of regions may be arranged symmetrically around the inner doped region. The plurality of regions may be equally spaced on a circular line concentric with the inner doped region. With such arrangement, a spacing may be provided between adjacent outer doped regions, while the outer doped regions do not fully enclose the inner doped region. The arrangement may still ensure that uniform field lines are formed around the inner doped region and may facilitate that a localized electric field peak is formed.

According to a second aspect, there is provided a sensor array, comprising: an array of single-photon avalanche diodes, SPADs, wherein each SPAD in the array of SPADs is a SPAD according to the first aspect; wherein the second terminals of each of the SPADs are commonly connected.

Effects and features of this second aspect are largely analogous to those described above in connection with the first aspect. Embodiments mentioned in relation to the first aspect are largely compatible with the second aspect.

Thanks to having an array of SPADs, two-dimensional imaging using the SPADs is enabled.

The second terminals may be commonly connected, which reduces the number of connections to the array of SPADs.

According to an embodiment, the first terminals of each of the SPADs are separately connected for separate read-out of light detected by each of the SPADs.

Thus, while the second terminals may be commonly connected, the first terminals being separately connected still ensures that each of the SPADs may be separately read out for two-dimensional imaging.

According to an embodiment, the outer regions of each of the SPADs are shared and form a single coherent region.

This may be a simple manner of forming the outer regions, as the outer regions of different SPADs need not necessarily be separated from each other.

Also, in some embodiments, such as when a plurality of outer regions is provided, an outer region may be shared by more than one SPAD.

According to an embodiment, a deep trench isolation structure is provided between each pair of adjacent SPADs in the array of SPADs.

This may reduce optical crosstalk between adjacent SPADs.

According to an embodiment, lowly doped depletion volumes of adjacent SPADs transition into each other and a lowly doped depletion volume belonging to an individual SPAD is defined by a pitch of the array of SPADs.

This may facilitate forming of the lowly doped depletion volume. The individual SPADs may be defined by the arrangement of the outer doped regions and inner doped regions such that field lines are defined within the individual SPADs and crosstalk is avoided.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 shows a cross-section of the doping profile of a prior art planar NIR-enhanced SPAD as disclosed in Takai, Isamu, et al. "Single-photon avalanche diode with enhanced NIR-sensitivity for automotive LIDAR systems." Sensors 16.4 (2016): 459.
Fig. 2 shows a cross-section of the doping profile of a reach through prior art NIR-enhanced SPAD as disclosed in Grubišić, D., and A. Shah. "New silicon reach-through avalanche photodiodes with enhanced sensitivity in the DUV/UV wavelength range." 2013 36th International Convention on Information and Communication Technology, Electronics and Microelectronics (MIPRO). IEEE, 2013.
Fig. 3 shows a cross-section of the doping profile of one embodiment of a NIR-enhanced SPAD with a geometry-constrained field peak around a rotationally symmetric inner doped region. Field lines and the multiplication region are indicated.
Fig. 4 shows a non-exhaustive set of horizontal cross-sections of possible arrangement of different device regions in a NIR-enhanced SPAD array with geometry-constrained field peaks.
Fig. 5 shows a doping profile, normalized electric field and depletion region edge near a top interface of a SPAD with a geometry-constrained field. The rotationally symmetric axis is located at x = 0 µm.

### Detailed description

There is a strong interest in the development of SPAD arrays in silicon. This allows for the exploitation of well-established semiconductor processing platforms and simplifies the on-chip integration of CMOS circuitry. Furthermore, silicon detectors generally exhibit better noise characteristics than germanium and III-V counterparts. However, a large disadvantage of silicon is the low NIR absorption coefficient, and therefore a low photon detection probability (PDP).

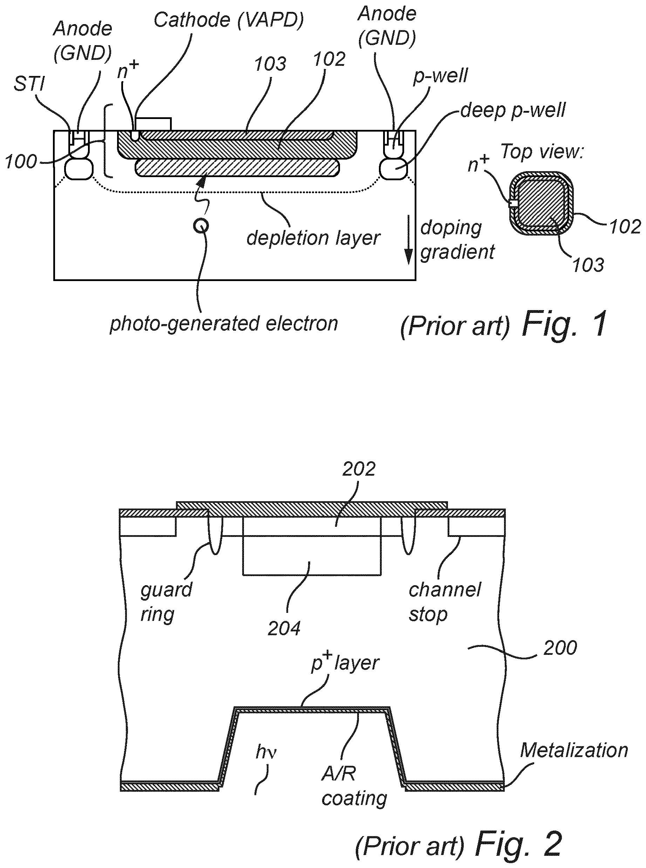

Reference is now made to Fig. 1, which is based on Figure 1 of Takai, Isamu, et al. "Single-photon avalanche diode with enhanced NIR-sensitivity for automotive LIDAR systems.", Sensors 16.4 (2016): 459. Typically, NIR-enhanced SPADs 100 rely on deep pn-junctions formed by stacked p-type 103 and n-type 102 implants. They are fabricated in a CMOS compatible platform with limited custom processing steps. The guard ring surrounding the junctions is relatively simple and small, and the SPADs can be integrated into dense arrays. An example of the doping profile of such a device is given in Fig. 1. The junction contains a laterally uniform high-field region parallel to the top device interface. This approach has two shortcomings:
- The absorption depth remains limited to a couple of microns. As a result, the single photon detection efficiency is typically not larger than 10 % at 905 nm.
- Carriers absorbed on the sides of the junction have a lower detection probability, as they may not be transported through the high-field region or recombine too soon. This limits the photon detection efficiency of SPADs integrated into arrays. The size of the peripheral region is determined by the size of the guard ring, device contacts and any additional in-pixel circuits.

Reference is now made to Fig. 2, which is based on the Figure on page 1 of Grubišić, D., and A. Shah. "New silicon reach-through avalanche photodiodes with enhanced sensitivity in the DUV/UV wavelength range." 2013 36th International Convention on Information and Communication Technology, Electronics and Microelectronics (MIPRO). IEEE, 2013. The absorption depth may be increased to tens of microns by introducing a deep absorption region 200 below the top pn-junction as demonstrated in Fig. 2. The device is now called a reach through SPAD. The absorption region is lowly doped and fully depleted such that generated carriers are transported quickly towards the multiplication field. The main junction is still formed by dedicated p-type implants 204 and n-type implants 202 parallel to the top interface. The high field region remains contained within this junction. The addition of the thick depleted region results in additional shortcomings:
- The breakdown voltage is high (>> 100 V) because the electric field distributes over the entire depleted volume from the moment the top pn-junction becomes depleted. Besides, the depletion behavior relies strongly on the doping profile of the top junction. This results in large sensitivity to process fluctuations. More specifically, small variations in the doping profile can result in large variations in the device behavior and breakdown voltage.
- If the absorption region is too deep, the transport time variance of carriers generated throughout the device may be poor (>> 200 ps).
- Reach through SPADs are generally less suitable for monolithic integration into dense arrays. They tend to have a large diameter, require large peripheral structures, suffer from uniformity issues and/or sometimes use non-standard processing steps.
- The detection efficiency loss due to the lack of multiplication of charges from the periphery remains.

Typically, planar silicon NIR-enhanced SPAD designs rely on the doping profile of some sort of pn- or pin-junction for the formation of the multiplication field. Active measures are taken to prevent premature breakdown at the junction edges.

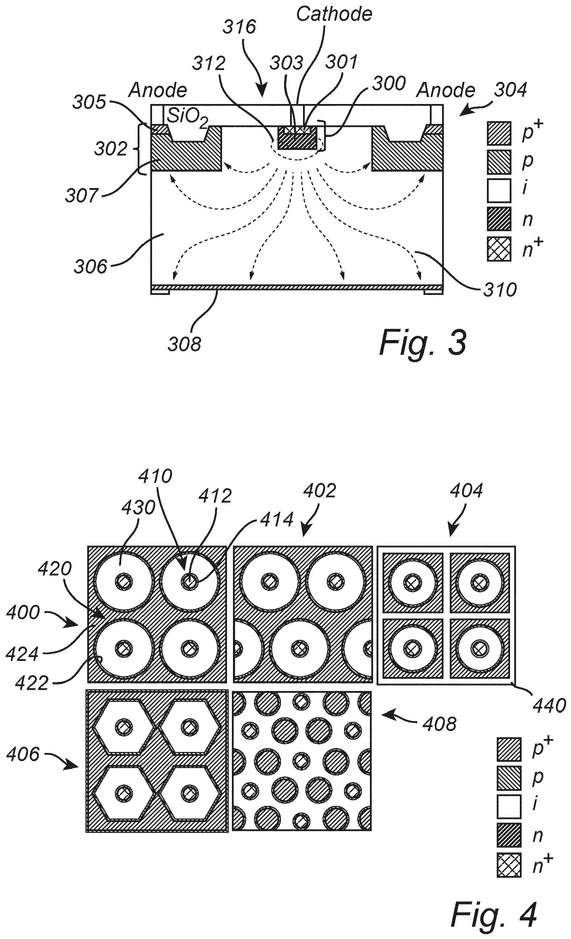

Fig. 3 demonstrates the doping profile and electric field of a planar silicon SPAD based on separate absorption and multiplication (SAM). The doping profile consists of multiple inner n-type doping implantations 300 and outer p-type doping implantations 302 for the formation of the cathode and anode respectively. The anode encloses the cathode in the horizontal cross-section near the top oxide interface 304. The cathode and anode are separated by a lowly doped p-type 306 (nearly) fully depleted volume which extends up to tens of microns deep. The lowly doped volume terminates at the back of the device 308. The anode is reverse biased above the breakdown voltage, and the backside 308 is biased at the same voltage as the anode. A dedicated doping implant for creating the multiplication field is absent. Consequently, the device relies on the geometry of the implants for the formation of a localized uniform field peak 312 near the cathode, rather than on the doping profile of a steep pn-junction. More specifically, the geometry enforces the crowding of the electric field lines 310, 312 near the cathode, as demonstrated in Fig. 3. The field peak 312 is spherically uniform around the cathode but remains spaced away from the oxide interface. For optimal NIR detection efficiency, the device is illuminated from the backside 308, so called backside illumination (BSI) 308. However, the device may alternatively be illuminated from a frontside 316, so called frontside illumination (FSI). The device is intended for the integration into large uniform monolithic arrays wherein all anodes are commonly connected, and each cathode is connected to a separate readout circuit. Doping types may be interchanged. If so, the cathodes are commonly connected while the anodes are separately read out.

A single SPAD in an array can be described generically as follows:
- An electrically connected inner doped region 300 comprising of one or more shallow narrow rotationally symmetric dopant implantations of a first type.
- One or more electrically connected outer doped regions 302 comprising of one or more dopant implantations of a second type, partially or fully enclosing the inner doped region in a horizontal cross-section.
- A lowly doped region 306 of either the first type or second type separating and surrounding the inner doped region 300 and outer doped region 302 and extending to the backside 308 of the device.
- At the operating voltage:
   ∘ An approximately spherically uniform electric field peak 312 surrounding the inner doped region 300, sufficiently high to enable impact ionization and Geiger mode multiplication.
   ∘ An electric field 310 in the lowly doped region 306, such that the lowly doped region 306 is (nearly) fully depleted and the therein generated carriers move quickly to the device electrodes.

The SPAD detector may have the following properties and features (in no particular order):
- The detector is made of silicon and has a breakdown voltage near or below 50 V. This allows for relatively easy monolithic integration, system integration and CMOS compatibility (using a custom process).
- The narrow inner doped region 300 is surrounded by an approximately uniform field peak 312. The field peak 312 does not extend to the oxide interface. Charges moving in any direction through the field peak 312 have large probabilities of being multiplied through impact ionization. Charges generated in the lowly doped volume 306 below the outer doped regions 302 are also multiplied efficiently (these charges would typically not be multiplied in 'standard' SPADs). The field peak 312 is formed by the local crowding of the electric field lines 310. In reference to a 'standard' SPAD with a steep pn-junction, this behavior can be thought of as 'controlled' premature edge breakdown.
- The NIR photon detection efficiency is high (> 15 % at 905 nm) because the lowly doped volume 306 is a least 10 µm deep. The temporal response (in particular, transport time variance) remains acceptable (< 200 ps) because the lowly doped region 306 is (nearly) fully depleted such that a sloped electric field is present directed away from the cathode.
- The sensitivity to process variations is low, resulting in high device uniformity. The main cause of non-uniformity for the device illustrated in Fig. 2 is the vertical doping profile (implantation dose and energy) of the steep pn-junction near the top interface. In the absence of the deeper doped region, this source of variability is removed. However, this doped region is responsible for creating the junction in which a laterally uniform field peak can develop. In the absence of this region, the device illustrated in Fig. 2 would either have an unreasonably high breakdown voltage (>> 1000 V) or prematurely breakdown at the junction edges resulting in poor NIR sensitivity. In the presently disclosed device, the wide pn-junction is replaced by a narrow central doped region 300 from which the depletion region extends gradually into the lowly doped region 306 as the reverse bias is increased. Due to the geometry, the field line density is higher near the narrow central implant 300 resulting in a local field peak 312.

Features of an embodiment of the SPAD detector can be summarized as follows:
The device employs a geometry-constrained uniform field peak 312 around a narrow central doped region 300. The field extends into a deep lowly doped region 306. Compared to other silicon NIR-enhanced SPAD architectures, this allows for higher NIR photon detection efficiency, near-unity BSI fill factor, acceptable breakdown voltage and lower sensitivity to process variations. The time resolution also remains acceptable for time-of-flight applications.

The shapes, doping profiles and relative sizes of the different design elements may facilitate these features. In the invention, the inner doped region 300 is small and rotationally symmetric to allow for an approximately spherically uniform field peak 312. On the other hand, the outer doped region 306 need not necessarily comply with specific symmetries, as long as the shape does not affect the uniformity of the field peak 312 and allows for efficient depletion and a low breakdown voltage.

Fig. 4 demonstrates a non-exhaustive set of horizontal cross sections near the top interface of possible arrangements 400, 402, 404, 406, 408 of the doped regions in an array of SPADs. The arrangement 400 may be preferred. Deep trench isolation (DTI) 440 may be employed to reduce optical crosstalk.

The following list enumerates non-exhaustive guidelines and constraints on the different elements of the disclosed device (in no particular order) such that the beforementioned features may be obtained:
- The inner doped region 300, 410 consists of a moderately doped region 303, 414 with a concentration between 1e16 cm⁻³ and 1e18 cm⁻³, and a highly doped region 301, 412 at the interface with a concentration above 1e18 cm⁻³. The highly doped region 301, 412 is fully enclosed by the moderately doped region 303, 414. Its purpose is the formation of an ohmic contact with a metal electrode. The inner doped region 300, 410 is non-depleted to a high degree at the operating conditions. The doping concentration has a limited contribution to the shape of the field peak.
- The surrounding surface of the inner doped region 300, 410 at the doping transition to the lowly doped region 306, 430 is rotationally symmetric and has a depth and radius between 0.3 µm and 1.5 µm, for example approximately 0.7 µm. The surface contains no sharp corners or excessively steep doping gradients, for example steeper than 1e19 cm⁻³µm⁻¹. The small size of the region enforces local crowding of the electric field lines. This results in a local field peak in which impact ionization and Geiger mode multiplication can occur. The size is sufficiently small to allow for a breakdown voltage near or below 50 V. The shape should encourage the formation of a spherically uniform field peak, for example, by having a radius-to-depth ratio around 1.
- The outer doped region 302, 420 consists of a moderately doped region 307, 422 with concentration between 1e14 cm⁻³ and 1e18 cm⁻³, and a highly doped region 305, 424 at the interface with a concentration above 1e18 cm⁻³. The purpose of the highly doped region 305, 424 is the formation of an ohmic contact with a metal electrode. The highly doped region 305, 424 is not depleted, while the moderately doped region 307, 422 may be partially depleted near its surrounding surface at the doping transition to the lowly doped region 306, 430.
- The outer doped region 302, 420 is diffused downwards and reaches a maximum depth between 0.5 µm and 4 µm, for example 3 µm. Its shape and size are such that the remainder of the device can be depleted to a high degree, and such that the field peak 312 around the inner doped region 300 may be spherically uniform.
- The combined doping profiles of the inner doped region 300, 410 and outer doped region 302, 420 near the top oxide interface 304 are such that the field peak 312 around the inner doped region 300, 410 does not extend entirely to the top oxide interface 304. Consequently, charges generated on this defective oxide interface have a lower probability of being multiplied. Additionally, charge trapping of carriers generated by an avalanche event is less likely. This condition may be satisfied by increasing the distance between the inner and outer doped regions near the interface, for example, by making the outer doped region bulge inwards on the interface
- Preferentially, the outer doped region 302, 420 encloses the inner doped region 300, 410 in a circular way. This encourages the formation of a spherically uniform field peak 312 around the inner doped region 302, 420.
- Optionally, a shallow lowly doped region of the first type may be present at the top interface. It may have a depth smaller than 200 nm and the concentration between 1e12 cm⁻³ and 1e15 cm⁻³. The purpose of this region is to further reduce the field peak on the top interface. However, it also affects how the electric field builds up in the remainder of the device. The shallow lowly doped region is highly depleted at the operating condition.
- The minimal spacing between the inner 300, 410 and outer 302, 420 doped regions may be between 2 µm and 10 µm, for example 5 µm. If the spacing is too large, full depletion of the lowly doped region 306, 430 at the breakdown voltage may be difficult in the horizontal direction. If the spacing is too small, horizontal depletion may occur at a (significantly) lower voltage than the breakdown voltage. Depending on the depth of the lowly doped region 306, 430, the latter may force a preferential field build-up and breakdown in the vertical or horizontal direction.
- The lowly doped region 306, 430 may be of either the first or second doping type. It may have a doping concentration between 1e14 cm⁻³ and 0 cm⁻³, for example 1e12 cm⁻³. The doping may be slightly graded in the downward direction. The nearly intrinsic doping enables easy depletion of the device and ensures that the electric field is not constrained by doping ions in the depleted volume.
- The lowly doped region 306, 430 may have a depth between 5 µm and 30 µm, for example 10 µm. The depth may be between 1 and 4 times larger than the minimum spacing between the inner doped region 300, 410 and outer doped region 302, 420, for example 2 times larger. If the depth is too large, full depletion of the lowly doped region at the breakdown voltage may be difficult in the vertical direction. If the depth is too small, vertical depletion may occur at a (significantly) lower voltage than the breakdown voltage. Depending on the minimal spacing between the different doped regions and detector pitch, the latter may force a preferential field build-up and breakdown in the vertical or horizontal direction.
- Optionally, the volume below the lowly doped region may be absent. If so, the device may be backside illuminated. If not, the volume may have a uniform doping concentration above 1e18 cm³. The doping may gradually transition into the lowly doped region 306 over a distance below 5 µm.
- Optionally, if the device is backside illuminated, a highly doped region may be present on the backside with a concentration above 1e18 cm⁻³ and a thickness below 1 µm.
- The pitch of SPADs in an array may be between 5 µm and 30 µm, for example 15 µm. If the pitch is too large, non-depleted regions may be present between SPADs and below the outer doped regions. Additionally, the large intermediate volume encourages thermal generation and noise. If the pitch is too small, the depletion regions of SPADs may overlap. This may influence the way the electric field builds up in the SPADs, for example, because each SPAD depletes faster in the horizontal direction compared to the vertical direction. Furthermore, a small pitch encourages optical crosstalk.

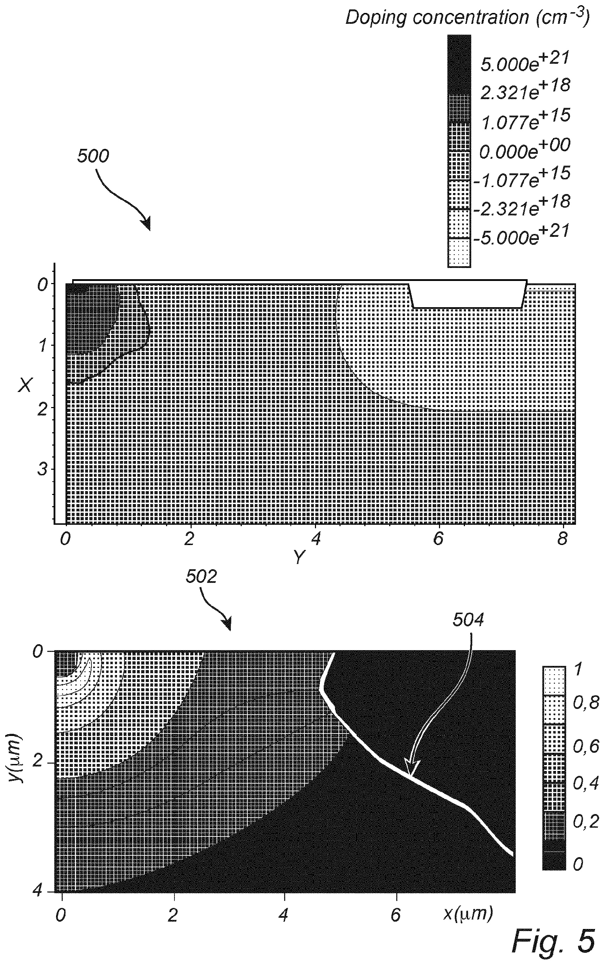

In conclusion, the electric field distribution is determined by all geometry and doping elements. Co-optimization of these elements is therefore required. As an example, Fig. 5 shows the doping profile 500 in a top graph of Fig. 5, a normalized electric field 502 and depletion region 504 in a bottom graph of Fig. 5 near the top device interface in a relatively well-optimized design.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A single-photon avalanche diode, SPAD, for use in a complementary metal-oxide-semiconductor, CMOS, integrated circuit and adapted for detection of light, such as visible or near infrared light, the SPAD comprising:
a semiconductor substrate comprising a top surface at a front side (316) and a back side (308) opposite to the front side (316);
an inner doped region (300, 410) disposed at a top surface of a semiconductor substrate connected to a first terminal, wherein a geometrical structure of a boundary of the inner doped region (300, 410) is rotationally symmetric in a horizontal direction of the semiconductor substrate and wherein the inner doped region (300, 410) comprises dopant implantations of a first type;
at least one outer doped region (302, 420) disposed at a top surface of a semiconductor substrate connected to a second terminal, wherein the at least one outer doped region (302, 420) is arranged to at least partially enclose the inner doped region (300, 410) in the horizontal direction of the semiconductor substrate and wherein the outer doped region (302, 420) comprises dopant implantations of a second type;
a lowly doped depletion volume (306, 430), which is arranged to surround the rotationally symmetric inner doped region (300, 410) and which comprises dopant implantations of the first type or dopant implantations of the second type;
wherein a depth of the lowly doped depletion volume (306, 430) extending from the top surface of the semiconductor substrate into the semiconductor substrate is larger than a depth of the at least one outer doped region (302, 420),
wherein the second terminal and the back side (308) of the semiconductor substrate are commonly connected, and wherein one of the first and the second terminal forms an anode and another of the first and the second terminal forms a cathode, the anode and the cathode being separated by the lowly doped depletion volume (306, 430);
wherein the SPAD is configured such that, when a reverse bias is applied to the anode, an electric field peak (312) around the inner doped region (300, 410) is formed to enable impact ionization and multiplication of charges; and
**characterized in that** II the inner doped region is small and a surface of the inner doped region (300, 410) at a doping transition to the lowly doped region (306, 430) is rotationally symmetric and contains no sharp corners, such that the electric field peak (312) is spherically uniform around the first terminal and spaced away from the top surface.

2. The SPAD according to claim 1, wherein the at least one outer doped region (302, 420) is arranged to at least partially enclose the inner doped region (300, 410) such that, when the reverse bias is applied to the anode, a surface of a space charge region at the at least one outer doped region (302, 420) is larger than a surface of a space charge region at the inner doped region (300, 410).

3. The SPAD according to claim 1 or 2, wherein a ratio of a depth of the lowly doped depletion volume (306, 430) to a horizontal spacing at the top surface between the inner doped region (300, 410) and the outer doped region (302, 420) is in a range of 1-4.

4. The SPAD according to any one of the preceding claims, wherein the lowly doped depletion volume (306, 430) is configured to extend to a highly doped region at the back side (308).

5. The SPAD according to any one of the preceding claims, wherein the inner doped region (300, 410) comprises an innermost region surrounded by an outermost region, wherein the innermost region has a higher doping concentration than the outermost region.

6. The SPAD according to any one of the preceding claims, wherein each of the at least one outer doped region (302, 420) comprises a highly doped region (305, 424) and a moderately doped region (307, 422), the highly doped region (305, 424) having a higher doping concentration than the moderately doped region (307, 422).

7. The SPAD according to any one of the preceding claims, wherein the outer doped region (302, 420) comprises a portion bulging inwards from the top surface.

8. The SPAD according to any one of the preceding claims, further comprising a shallow lowly doped region at the top surface between the inner doped region (300, 410) and the outer doped region (302, 420) and above the lowly doped depletion volume.

9. The SPAD according to any one of the preceding claims, wherein the at least one outer doped region (302, 420) is configured to completely enclose the inner doped region (300, 410) in the horizontal direction of the semiconductor substrate.

10. The SPAD according to claim 9, wherein the at least one outer doped region (302, 420) is configured to circularly enclose the inner doped region (300, 410).

11. The SPAD according to any one of claims 1-8, wherein the at least one outer region (302, 420) comprises a plurality of outer regions, wherein the plurality of outer regions together enclose the inner doped region (300, 410) forming an n-fold symmetry around the inner doped region (300, 410), where n > 3.

12. A sensor array, comprising:
an array of single-photon avalanche diodes, SPADs, wherein each SPAD in the array of SPADs is a SPAD according to any one of the preceding claims;
wherein the second terminals of each of the SPADs are commonly connected.

13. The sensor array according to claim 12, wherein the first terminals of each of the SPADs are separately connected for separate read-out of light detected by each of the SPADs.

14. The sensor array according to claim 12 or 13, wherein the outer regions (302, 420) of each of the SPADs are shared and form a single coherent region.

15. The sensor array according to claim 12 or 13, wherein a deep trench isolation structure (440) is provided between each pair of adjacent SPADs in the array of SPADs.

## Patentansprüche

1. Ein-Photonen-Lawinendiode, SPAD, zur Verwendung in einer integrierten Schaltung eines Komplementär-Metalloxid-Halbleiters, CMOS, und die zur Detektion von Licht, wie etwa sichtbarem oder nah infrarotem Licht geeignet ist, wobei die SPAD umfasst:
ein Halbleitersubstrat, das eine obere Oberfläche auf einer Vorderseite (316) und einer Rückseite (308) gegenüber der Vorderseite (316) umfasst;
eine innere dotierte Region (300, 410), die auf einer oberen Oberfläche eines Halbleitersubstrats angeordnet ist, die an eine erste Anschlussklemme angeschlossen ist, wobei eine geometrische Struktur einer Begrenzung der inneren dotierten Region (300, 410) rotationssymmetrisch in einer horizontalen Richtung des Halbleitersubstrats ist, und wobei die innere dotierte Region (300, 410) Dotierstoffimplantationen eines ersten Typs umfasst;
mindestens eine äußere dotierte Region (302, 420), die auf einer oberen Oberfläche eines Halbleitersubstrats angeordnet ist, die an eine zweite Anschlussklemme angeschlossen ist, wobei die mindestens eine äußere dotierte Region (302, 420) dazu eingerichtet ist, die innere dotierte Region (300, 410) in der horizontalen Richtung des Halbleitersubstrats mindestens teilweise einzuschließen, und wobei die äußere dotierte Region (302, 420) Dotierstoffimplantationen eines zweiten Typs umfasst;
ein schwach dotiertes Verarmungsvolumen (306, 430), das dazu eingerichtet ist, die rotationssymmetrische innere dotierte Region (300, 410) zu umgeben, und das Dotierstoffimplantationen des ersten Typs oder Dotierstoffimplantationen des zweiten Typs umfasst;
wobei eine Tiefe des schwach dotierten Verarmungsvolumens (306, 430), das sich von der oberen Oberfläche des Halbleitersubstrats in das Halbleitersubstrat erstreckt, größer als eine Tiefe der mindestens einen äußeren dotierten Region (302, 420) ist,
wobei die zweite Anschlussklemme und die Rückseite (308) des Halbleitersubstrats gemeinsam angeschlossen sind, und wobei eine von der ersten und der zweiten Anschlussklemme eine Anode bildet, und eine andere von der ersten und der zweiten Anschlussklemme eine Kathode bildet, wobei die Anode und die Kathode durch das schwach dotierte Verarmungsvolumen (306, 430) getrennt sind;
wobei die SPAD derart konfiguriert ist, dass wenn eine Sperrvorspannung an die Anode angelegt wird, eine elektrische Feldspitze (312) um die innere dotierte Region (300, 410) herum gebildet wird, um eine Stoßionisation und eine Multiplikation von Ladungen zu ermöglichen; und
**dadurch gekennzeichnet, dass** die innere dotierte Region klein ist, und eine Oberfläche der inneren dotierten Region (300, 410) an einem Dotierungsübergang zu der schwach dotierten Region (306, 430) rotationssymmetrisch ist und keine spitzen Ecken enthält, so dass die elektrische Feldspitze (312) um die erste Anschlussklemme herum sphärisch einheitlich und von der oberen Oberfläche beabstandet ist.

2. SPAD nach Anspruch 1, wobei die mindestens eine äußere dotierte Region (302, 420) dazu eingerichtet ist, die innere dotierte Region (300, 410) mindestens teilweise einzuschließen, so dass, wenn die Sperrvorspannung an die Anode angelegt wird, eine Oberfläche einer Raumladungsregion an der mindestens einen äußeren dotierten Region (302, 420) größer als eine Oberfläche einer Raumladungsregion an der inneren dotierten Region (300, 410) ist.

3. SPAD nach Anspruch 1 oder 2, wobei ein Verhältnis einer Tiefe des schwach dotierten Verarmungsvolumens (306, 430) zu einer horizontalen Beabstandung an der oberen Oberfläche zwischen der inneren dotierten Region (300, 410) und der äußeren dotierten Region (302, 420) in einem Bereich von 1 bis 4 liegt.

4. SPAD nach einem der vorhergehenden Ansprüche, wobei das schwach dotierte Verarmungsvolumen (306, 430) dazu konfiguriert ist, sich bis zu einer hoch dotierten Region auf der Rückseite (308) zu erstrecken.

5. SPAD nach einem der vorhergehenden Ansprüche, wobei die innere dotierte Region (300, 410) eine innerste Region umfasst, die von einer äußersten Region umgeben ist, wobei die innerste Region eine höhere Dotierungskonzentration als die äußerste Region aufweist.

6. SPAD nach einem der vorhergehenden Ansprüche, wobei jede von der mindestens einen äußeren dotierten Region (302, 420) eine hoch dotierte Region (305, 424) und eine mittel dotierte Region (307, 422) umfasst, wobei die hoch dotierte Region (305, 424) eine höhere Dotierungskonzentration als die mittel dotierte Region (307, 422) aufweist.

7. SPAD nach einem der vorhergehenden Ansprüche, wobei die äußere dotierte Region (302, 420) einen Abschnitt umfasst, der von der oberen Oberfläche aus nach innen gewölbt ist.

8. SPAD nach einem der vorhergehenden Ansprüche, ferner umfassend eine flache schwach dotierte Region auf der oberen Oberfläche zwischen der inneren dotierten Region (300, 410) und der äußeren dotierten Region (302, 420) und über dem schwach dotierten Verarmungsvolumen.

9. SPAD nach einem der vorhergehenden Ansprüche, wobei die mindestens eine äußere dotierte Region (302, 420) dazu konfiguriert ist, die innere dotierte Region (300, 410) in der horizontalen Richtung des Halbleitersubstrats vollständig einzuschließen.

10. SPAD nach Anspruch 9, wobei die mindestens eine äußere dotierte Region (302, 420) dazu konfiguriert ist, die innere dotierte Region (300, 410) kreisförmig einzuschließen.

11. SPAD nach einem der Ansprüche 1 bis 8, wobei die mindestens eine äußere Region (302, 420) eine Vielzahl von äußeren Regionen umfasst, wobei die Vielzahl von äußeren Regionen zusammen die innere dotierte Region (300, 410) einschließen und dabei eine n-fache Symmetrie um die innere dotierte Region (300, 410) herum bilden, wobei n > 3.

12. Sensoranordnung, umfassend:
eine Anordnung von Ein-Photonen-Lawinendioden, SPADs, wobei jede SPAD in der Anordnung von SPADs eine SPAD nach einem der vorhergehenden Ansprüche ist;
wobei die zweiten Anschlussklemmen jeder der SPADs gemeinsam angeschlossen sind.

13. Sensoranordnung nach Anspruch 12, wobei die ersten Anschlussklemmen jeder der SPADs zum getrennten Auslesen von Licht, das von jeder der SPADs detektiert wird, getrennt angeschlossen sind.

14. Sensoranordnung nach Anspruch 12 oder 13, wobei die äußeren Regionen (302, 420) jeder der SPADs gemeinsam genutzt werden, um eine einzige zusammenhängende Region zu bilden.

15. Sensoranordnung nach Anspruch 12 oder 13, wobei eine Tiefgrabenisolationsstruktur (440) zwischen jedem Paar von angrenzenden SPADs in der Anordnung von SPADs bereitgestellt wird.

## Revendications

1. Diode à avalanche à photon unique, SPAD, destinée à être utilisée dans un circuit intégré semi-conducteur complémentaire à oxyde métallique, CMOS, et adaptée pour la détection de lumière, telle que la lumière visible ou proche infrarouge, la SPAD comprenant :
un substrat semi-conducteur comprenant une surface supérieure sur une face avant (316) et une face arrière (308) opposée à la face avant (316) ;
une région dopée intérieure (300, 410) disposée au niveau d'une surface supérieure d'un substrat semi-conducteur connecté à une première borne, dans laquelle une structure géométrique d'une limite de la région dopée intérieure(300, 410) est symétrique en rotation dans une direction horizontale du substrat semi-conducteur et dans laquelle la région dopée intérieure(300, 410) comprend des implantations de dopant d'un premier type ;
au moins une région dopée extérieure (302, 420) disposée sur une surface supérieure d'un substrat semi-conducteur connecté à une deuxième borne, dans laquelle la au moins une région dopée extérieure (302, 420) est agencée pour renfermer au moins partiellement la région (300, 410) dans la direction horizontale du substrat semi-conducteur et dans laquelle la région dopée extérieure (302, 420) comprend des implantations de dopant d'un deuxième type ;
un volume d'appauvrissement faiblement dopé (306, 430), qui est agencé pour entourer la région dopée intérieure à symétrie de rotation (300, 410) et qui comprend des implantations de dopants du premier type ou des implantations de dopants du deuxième type ;
dans laquelle une profondeur du volume d'appauvrissement faiblement dopé (306, 430) s'étendant depuis la surface supérieure du substrat semi-conducteur dans le substrat semi-conducteur est plus grande qu'une profondeur d'au moins une région dopée extérieure (302, 420), dans laquelle la deuxième borne et la face arrière (308) du substrat semi-conducteur sont connectées en commun, et dans laquelle une de la premier et deuxième borne forme une anode et une autre de la première et de la deuxième borne forme une cathode, l'anode et la cathode étant séparées par le volume d'appauvrissement faiblement dopé (306, 430) ;
dans laquelle la SPAD est configurée de telle sorte que lorsqu'une polarisation inverse est appliquée à l'anode, un pic de champ électrique (312) autour de la région dopée intérieure (300, 410) est formé pour permettre l'ionisation par impact et la multiplication des charges ; et
**caractérisée en ce que** la région dopée intérieure est petite et une surface de la région dopée intérieure (300, 410) à une transition de dopage vers la région faiblement dopée (306, 430) est symétrique en rotation et ne contient pas d'angles vifs, de sorte que le pic de champ électrique (312) soit sphériquement uniforme autour de la première borne et espacé de la surface supérieure.

2. SPAD selon la revendication 1, dans laquelle la au moins une région dopée extérieure (302, 420) est agencée pour renfermer au moins partiellement la région dopée intérieure (300, 410) de sorte que, lorsque la polarisation inverse est appliquée à l'anode , une surface d'une région de charge d'espace au niveau de la au moins une région dopée extérieure (302, 420) soit plus grande qu'une surface d'une région de charge d'espace au niveau de la région dopée intérieure (300, 410).

3. SPAD selon la revendication 1 ou 2, dans laquelle un rapport d'une profondeur du volume d'appauvrissement faiblement dopé (306, 430) sur un espacement horizontal au niveau de la surface de sommet entre la région dopée intérieure (300, 410) et la région dopée extérieure (302, 420) est compris dans une plage de 1 à 4.

4. SPAD selon une quelconque des revendications précédentes, dans laquelle le volume d'appauvrissement faiblement dopé (306, 430) est configuré pour s'étendre jusqu'à une région fortement dopée au côté arrière (308).

5. SPAD selon une quelconque des revendications précédentes, dans laquelle la région dopée intérieure(300, 410) comprend une région la plus intérieure entourée d'une région la plus extérieure, la région la plus intérieure ayant une concentration de dopage plus élevée que la région la plus extérieure.

6. SPAD selon une quelconque des revendications précédentes, dans laquelle chacune de la au moins une région dopée extérieure (302, 420) comprend une région fortement dopée (305, 424) et une région modérément dopée (307, 422), la région fortement dopée (305, 424) ayant une concentration de dopage plus élevée que la région modérément dopée (307, 422).

7. SPAD selon une quelconque des revendications précédentes, dans laquelle la région dopée extérieure (302, 420) comprend une partie renflée vers l'intérieur à partir de la surface supérieure.

8. SPAD selon une quelconque des revendications précédentes, comprenant en outre une région faiblement dopée peu profonde à la surface supérieure entre la région dopée (300, 410) et la région dopée extérieure (302, 420) et au-dessus du volume d'appauvrissement faiblement dopé.

9. SPAD selon une quelconque des revendications précédentes, dans laquelle la au moins une région dopée extérieure (302, 420) est configurée pour renfermer complètement la région dopée intérieure (300, 410) dans la direction horizontale du substrat semi-conducteur.

10. SPAD selon la revendication 9, dans laquelle la au moins une région dopée extérieure (302, 420) est configurée pour renfermer circulairement la région dopée intérieure (300, 410).

11. SPAD selon une quelconque des revendications 1 à 8, dans laquelle la au moins une région extérieure (302, 420) comprend une pluralité de régions extérieures, dans laquelle la pluralité de régions extérieures entourent ensemble la région dopée intérieure (300, 410) en formant une symétrie n fois autour de la région dopée intérieure (300, 410), où n>3.

12. Réseau de capteurs, comprenant :
un réseau de diodes à avalanche à photon unique, SPAD, dans lequel chaque SPAD dans le réseau de SPAD est un SPAD selon une quelconque des revendications précédentes ;
dans lequel les deuxièmes bornes de chacun des SPAD sont connectées en commun.

13. Réseau de capteurs selon la revendication 12, dans lequel les premières bornes de chacune des SPAD sont connectées séparément pour une lecture séparée de la lumière détectée par chacune des SPAD.

14. Réseau de capteurs selon la revendication 12 ou 13, dans lequel les régions extérieures (302, 420) de chacun des SPAD sont partagées et forment une seule région cohérente.

15. Réseau de capteurs selon la revendication 12 ou 13, dans lequel une structure d'isolation à tranchée profonde (440) est prévue entre chaque paire de SPAD adjacents dans le réseau de SPAD.
